# EUROPÄISCHE PATENTSCHRIFT

(11) **EP 1 159 158 B1**
(45) Veröffentlichungstag und Bekanntmachung des Hinweises auf die Patenterteilung: **02.05.2003**
(21) Anmeldenummer: 00906163.1
(22) Anmeldetag: 24.01.2000
(51) Int. Cl.: B60R 16/02

(54) **METALLGEHÄUSE, INSBESONDERE FÜR EIN AIRBAG-STEUERGERÄT**
METAL HOUSING, ESPECIALLY FOR AN AIRBAG CONTROL DEVICE
BOITIER METALLIQUE, NOTAMMENT POUR UN APPAREIL DE COMMANDE D'AIRBAG

(30) Priorität: 17.03.1999 DE 19911990
(43) Veröffentlichungstag der Anmeldung: 05.12.2001
(73) Patentinhaber: TRW Automotive Electronics & Components GmbH & Co. KG, 78315 Radolfzell (DE); alutec Metallwaren GmbH & Co., 75447 Sternenfels (DE)
(72) Erfinder: LINKE, Ralph, D-78315 Radolfzell (DE); MASCHA, Georg, D-78315 Radolfzell (DE); KRETZ, Willy, D-75181 Pforzheim (DE)
(74) Vertreter: Schieschke, Klaus, Dipl.-Ing.
(86) Internationale Anmeldenummer: DE0000193
(87) Internationale Veröffentlichungsnummer: WO00055013

(56) Entgegenhaltungen:
- WO-A1-86/06334
- DE-A- 3 022 115
- DE-C- 4 123 261

## Beschreibung

Die Erfindung bezieht sich auf ein Gehäuse, insbesondere für ein Airbag-Steuergerät, mit Boden- und Deckplatte, mit einer Rückwand und mit zwei Seitenwänden mit Aufnahmeelementen im Inneren des Gehäuses für mindestens eine gedruckte Leiterplatte und einem an der Vorderseite des Gehäuses angeordneten Anschlusselement für mindestens ein Verbindungselement.

Als Stand der Technik ist bereits ein derartiges Gehäuse bekannt (DE-C-41 23 261). Dieses Gehäuse macht es erforderlich, dass es an die jeweiligen Einbaugegebenheiten angepasst werden muss. Es ergibt sich damit eine zusätzliche Lagerhaltung, wobei zudem sicher gestellt sein muss, dass die entsprechenden Teile funktionsrichtig montiert werden.

Ausgehend von dem vorgenannten Stand der Technik besteht die zu lösende Aufgabe darin, ein Gehäuse nach dem Oberbegriff des Anspruchs 1 derart weiterzubilden, dass auf einfache Weise ein schnell an die Montageumgebung anpassbares Element vorliegt.

Diese Aufgabe wird erfindungsgemäß dadurch gelöst, dass das Gehäuse ein Metallgehäuse ist und dass die Boden- und/oder die Deckplatte mit einer an einem Träger befestigbaren Montageplatte verbunden ist bzw. sind.

Dadurch ergibt sich der Vorteil, dass über die stets an die Montagegegebenheit angepasste Montageplatte lediglich ein einziges Metallgehäuse verwendet wird, welches beliebig mit dem betreffenden Träger verbunden werden kann. Es ist somit lediglich ein einzelner Gehäusetyp erforderlich, welcher über die jeweils der Montageumgebung angepasste Montageplatte an dem betreffenden Träger befestigt werden kann. Diese Montageplatte hat darüber hinaus Versteifungsfunktion, so dass sich insgesamt ein stabiles Gehäuse ergibt.

In weiterer Ausgestaltung der Erfindung kann die Boden- und/oder Deckplatte des einstückig ausgebildeten Gehäuses mit Vorsprüngen versehen sein, welche in Ausnehmungen der Montageplatte einlagerbar und verpressbar sind. Damit ergibt .sich eine wesentliche Montageerleichterung. Darüber hinaus können in weiterer Ausgestaltung der Erfindung die Vorsprünge in mehreren parallelen Reihen verlaufen und aus auf der Boden- und/oder Deckplatte angeformten Rippen und/oder Zeilen herausgearbeitet sein. Hierdurch ergibt sich vorteilhafterweise eine rasche und kostensparende Herstellung.

In weiterer Ausgestaltung der Erfindung können die Montageplatten die Bodenund/oder Deckplatte zumindest teilweise überragen und Befestigungsbereiche aufweisen, welche beispielsweise mit mindestens einer durchgehenden Öffnung versehen sind. Weiterhin besteht erfindungsgemäß die Möglichkeit, dass die eine mit drei Befestigungsbereichen versehene Montageplatte entweder an der Bodenplatte oder an der Deckplatte des Gehäuses befestigbar ist. Hierbei kann die Montageplatte an der Bodenplatte oder an der Deckplatte des Gehäuses gegenüber der Ausgangsposition um 180 Grad gedreht befestigbar sein. Durch diese spezielle Gestaltung der Befestigung der betreffenden Montageplatte ergeben sich viele Kombinationsmöglichkeiten, so dass das entsprechende Teilgehäuse bei vielen in der Praxis vorhandenen Kraftfahrzeugen einsetzbar ist, ohne dass eine spezielle Konfiguration erforderlich wäre.

Um trotz dieser Befestigung eine gute Führung der Leiterplatte im Inneren des Gehäuses zu gewährleisten, besteht in weiterer Ausgestaltung der Erfindung die Möglichkeit, dass die Seitenwände des einstückig ausgebildeten Gehäuses und die Rückwand mit Führungselementen für die Leiterplatte versehen ist. Hierbei können die Führungselemente der Seitenplatte als Nuten und die der Rückwand als elektrisch leitende Kontakte ausgebildet sein.

Nach einem anderen Merkmal der Erfindung können die Kontakte einen kabelförmigen Bereich zum Beaufschlagen und Lagern der Leiterplatte und einen mit der Rückwand verbindbaren Bereich aufweisen, welcher mit mindestens einer Öffnung zum Einlagern und Verprägen mit mindesten einem Vorsprung der Rückwand versehen ist.

Um eine weitere Montageerleichterung zu schaffen, besteht darüber hinaus die Möglichkeit, dass das Anschlusselement über mindestens eine Rastverbindung mit der Vorderseite des Gehäuses verbindbar ist. Hierbei können im Bereich der Vorderseite des Gehäuses Rastnasen vorgesehen sein, welche in Rastausnehmungen des aus Kunststoff bestehenden Anschlusselements einklippbar sind. Damit lassen sich auf einfache Weise das Anschlusselement und das einstückige Gehäuse funktionsrichtig miteinander verbinden.

Nach einem weiteren Merkmal der Erfindung kann zwischen dem Anschlusselement und der Vorderseite des Gehäuses eine umlaufende Kunststoffdichtung vorgesehen sein, wodurch der Anwendungsbereich noch erweitert wird.

Zur einfachen Herstellung des Gehäuses besteht nach einem anderen Merkmal der Erfindung die Möglichkeit, dass dieses im Fließpressverfahren hergestellt werden kann.

Die Erfindung wird nachfolgend anhand von in der Zeichnung dargestellten Ausführungsbeispielen näher beschrieben.

In der Zeichnung zeigen:
- Fig. 1: eine perspektivische Ansicht des erfindungsgemäßen Airbag-Steuergeräts
- Fig. 2: eine Draufsicht auf das Gerät nach Fig. 1;
- Fig. 3: einen Schnitt nach der Linie III-III gemäß Fig. 2;
- Fig. 4: eine perspektivische Ansicht des einstückigen Gehäuses;
- Fig. 5: eine Draufsicht auf eine Montageplatte;
- Fig. 6: eine vergrößerte Ansicht einer Rastnase an der Vorderseite des Gehäuses;
- Fig. 7: eine perspektivische Ansicht des vorderen Bereichs des Anschlusselements, teils gebrochen;
- Fig. 8: eine Vorderansicht des elektrisch leitenden Kontakts, teils gebrochen;
- Fig. 9: eine Seitenansicht des Kontakts nach Fig. 8;
- Fig. 10 bis Fig. 12: eine weitere Ausrührungsmöglichkeit des Metallgehäuses, teils in perspektivischer Ansicht, teils in Draufsicht;
- Fig. 13 bis Bis 15: eine weitere Gestaltungsmöglichkeit des Gehäuses in perspektivischer Ansicht, in Vorderansicht und in Draufsicht.

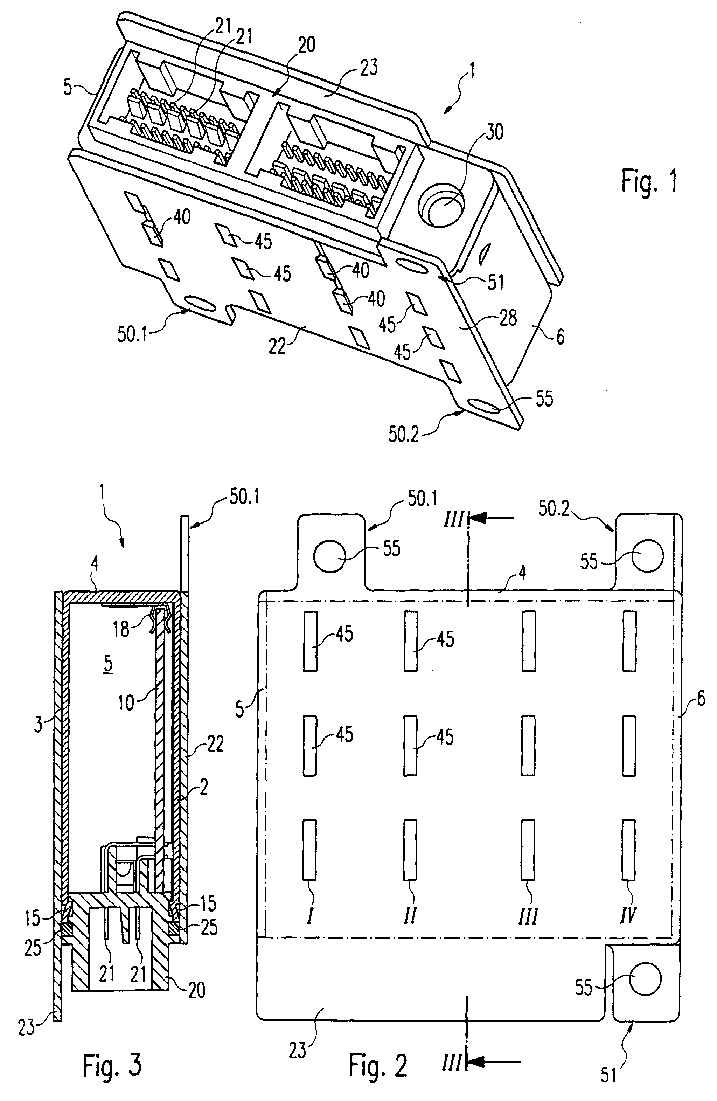

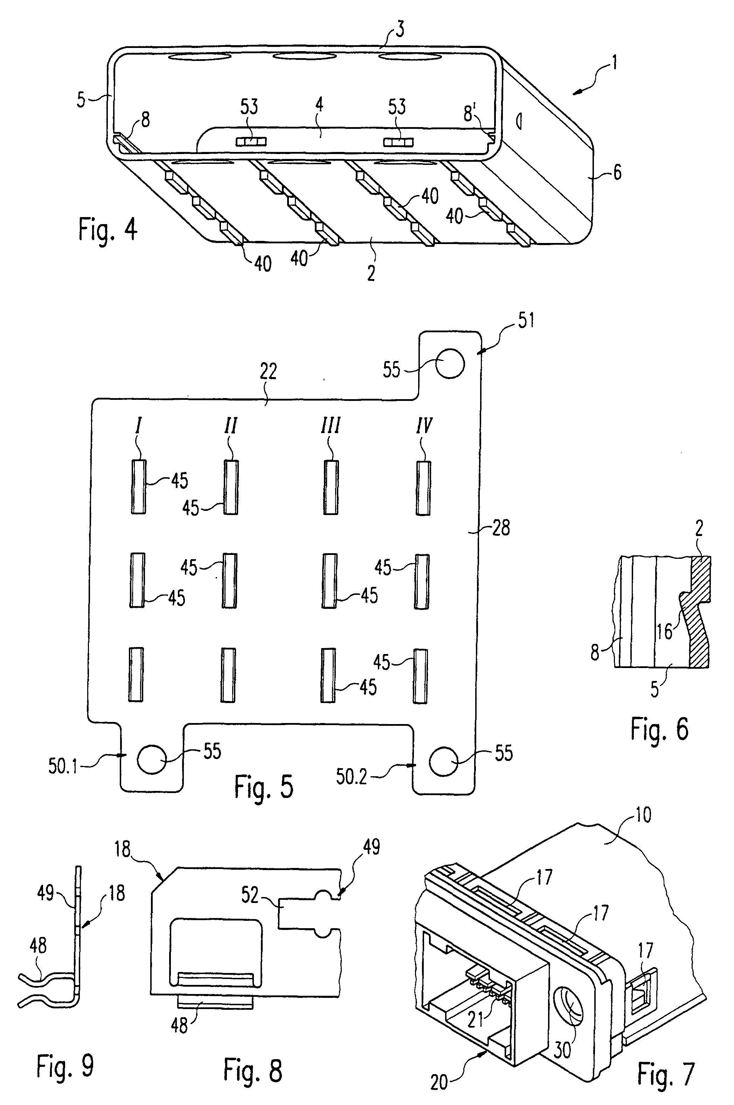

In Fig. 1 ist ein Metallgehäuse 1 dargestellt, welches insbesondere für ein Airbag-Steuergerät eingesetzt wird. Dieses Metallgehäuse weist insbesondere nach Fig. 4 eine Bodenplatte 2 sowie eine Deckplatte 3, eine Rückwand 4 und zwei Seitenwände 5 und 6 auf. Diese einzelnen Elemente des Gehäuses sind insgesamt einstückig ausgebildet, nämlich als ein vorzugsweise aus Aluminium bestehendes einteiliges Gehäuse, welches beispielsweise im Fließstrangpressverfahren in einem Arbeitsgang hergestellt wird.

Die Vorderseite des Gehäuses ist nach Fig. 1 durch ein Abschlusselement 20 dicht verschlossen. Hierzu ist das Anschlusselement 20 insbesondere nach Fig. 3 mit einer die Innenwandung und/oder die Stirnseite des Gehäuses 1 beaufschlagenden umlaufenden Dichtung 25 versehen, welche das Innere des einstückig Gehäuses 1 abdichtet. Das Anschlusselement 20 kann nach Fig. 3 und 7 Rastausnehmungen 17 aufweisen, welche in entsprechend gestaltete Rastnasen 16 (Fig. 3, Fig. 6) einklippbar sind. Damit ist eine rasche und sichere Verbindung zwischen dem aus Kunststoff bestehenden Anschlusselement 20 und dem vorzugsweise aus Aluminium bestehenden einstückigen Gehäuse 1 hergestellt.

Aus den Fig. 1 bis 5 geht hervor, dass erfindungsgemäß die Boden- und/oder die Deckplatte 2 und 3 mit einer an einem nicht näher dargestellten Träger befestigbaren Montageplatte 22 und 23 verbunden sind. Hierbei weist insbesondere nach Fig. 4 beispielsweise die Bodenplatte 2 Vorsprünge 40 auf, welche in Ausnehmungen 45 (Fig. 2, Fig. 5) der betreffenden Montageplatte 22 bzw. 23 einlagerbar und nach der Einlagerung verpressbar sind.

Vorzugsweise verlaufen nach Fig. 2 und 5 die Vorsprünge 40 in mehreren parallelen Reihen I, II, III und IV und sind auf der Boden- und/oder der Deckplatte angeformten Rippen herausgearbeitet, beispielsweise durch Fräsen. Durch das Einhalten eines bestimmten Rasters bzw. das Herstellen verschiedener Montageplatten 22 bzw. 23 mit verschiedenen Ausnehmungen entsteht damit insgesamt ein sehr einfach an die Montageumgebung anpassbares Metallgehäuse, insbesondere für ein Airbag-Steuergerät, welches an die verschiedensten Träger unterschiedlicher Fahrzeugtypen anbaubar ist.

Aus Fig. 3 geht hervor, dass die Montageplatten 22 und 23 die Boden- und/oder Deckplatten 2 bzw. 3 zumindest teilweise überragen und Befestigungsbereiche 50.1, 50.2 und 51 aufweisen. Nach Fig. 2 sind diese Befestigungsbereiche 50.1, 50.2 und 51 als mit mindestens einer durchgehenden Öffnung 55 versehene Flansche ausgebildet, wobei auch andere Konfigurationen denkbar sind. Über diese Montageplatten 22 und 23 und die entsprechend eingerichteten Befestigungsbereiche 50.1, 50.2 und 51 lässt sich damit ein übliches Standardgehäuse 1 an jeden beliebigen Träger anbauen.

Nach Fig. 3 und 4 sind die Seitenwände 5 und 6 des einstückigen Gehäuses 1 und die Rückwand 4 mit Führungselementen 8 und 8' bzw. 18 für die Leiterplatte 10 versehen. Die Führungselemente der Seitenwände 5 und 6 sind hierbei als Nuten ausgebildet. Die Führungselemente der Rückwand 4 können als elektrisch leitende Kontakte 18 gestaltet sein.

Gemäß Fig. 8 und 9 können die Kontakte 18 einen gabelförmigen Bereich 48 zum Beaufschlagen und Lagern der Leiterplatte 10 und einen mit der Rückwand verbindbaren Bereich 49 aufweisen, welcher mit mindestens einer Öffnung 52 zum Einlagern und Verprägen mit einem Vorsprung 53 der Rückwand 4 nach Fig. 4 versehen ist.

Damit ergibt sich eine einwandfreie und sichere Lagerung der Leiterplatte 10 nach Fig. 3 in dem mit den Montageplatten 22 und 23 versehenen Metallgehäuse 1.

Die Vorsprünge 40 an der Boden- und/oder Deckplatte 2 bzw. 3 müssen nicht nach Fig. 2 und 5 in einer Reihe verlaufen, sie können beispielsweise auch kreuzförmig ausgebildet sein oder eine andere Konfiguration aufweisen, je nach Gestaltung der betreffenden Trägerplatte 22 bzw. 23.

Bei der Ausführungsform nach Fig. 1 bis 3 befindet sich im Bereich der Öffnung 30 des Metallgehäuses 1 der Befestigungsbereich 51, welcher über eine Randleiste 28 mit dem Befestigungsbereich 50.0.2 verbunden ist. Parallel zur Rückwand 4 befindet sich der Befestigungsbereich 50.1, der als Flansch gestaltet ist.

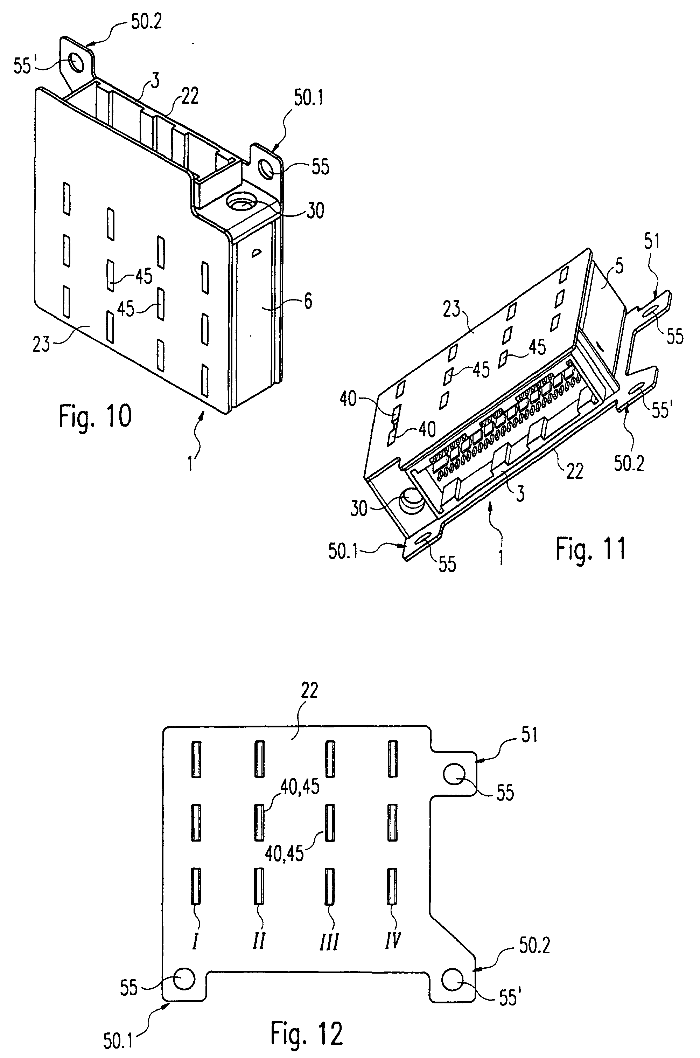

Bei der Ausführungsform nach Fig. 10 bis 12 ist die z.B. mit den drei Befestigungsbereichen 50.1, 50.2 und 50.3 ausgestattete Montageplatte 22 an der Deckplatte 3 des Metallgehäuses 1 befestigt, wobei die Montageplatte 3 um 180° gegenüber der Ausgangsposition gedreht ist. Folglich befindet sich im Bereich der Öffnung 30 des Metallgehäuses 1 der Befestigungsbereich 50.1 und parallel dazu der Befestigungsbereich 50.2, dessen Durchgangsöffnung 55' beispielsweise als Langloch ausgebildet ist. Parallel zur Seitenwand 5 des Metallgehäuses 1 ist der Befestigungsbereich 51 angeordnet, wobei die drei Bereiche 50.1, 50.2 und 51 jeweils als Flansche gestaltet sind.

Die Montageplatte 22 weist wiederum Ausnehmungen 45 auf, in welche analog der vorgenannten Ausführungsform nach Fig. 1 bis 3 Vorsprünge 40 eingelagert und nach der Einlagerung verpressbar sind.

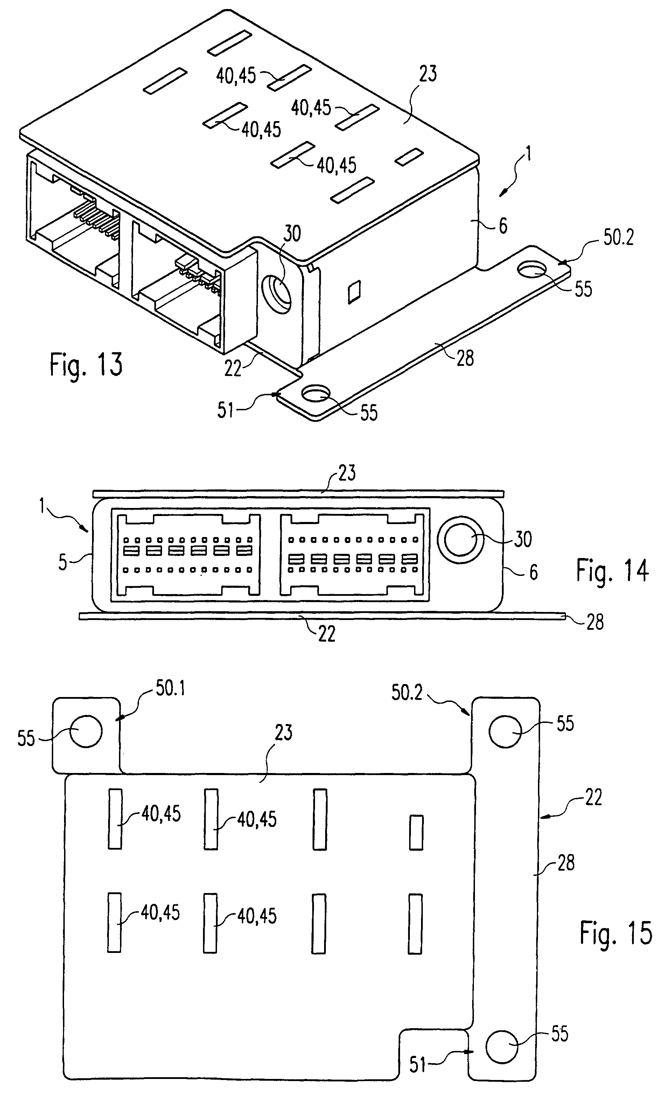

Fig. 13 bis 15 zeigt eine weitere Ausführungsmöglichkeit der Erfindung: Hier sind im Bereich der Öffnung 30 des Metallgehäuses 1 längsseitig der Seitenwand 6 die Befestigungsbereiche 50.2 und 51 am Ende einer Randleiste 28 angeordnet, wobei gemäß Fig. 15 der dritte Befestigungsbereich 50.1 wiederum als Flansch ausgebildet ist und sich längsseitig der Rückwand 4 des Metallgehäuses 1 erstreckt.

Allen Ausführungsformen ist gemeinsam, dass die eine mit drei Befestigungsbereichen 50.1, 50.2 und 51 versehene Montageplatte 22 entweder an der Bodenplatte 2 oder an der Deckplatte 3 des Gehäuses 1 über die Ausnehmungen 45 und die Vorsprünge 40 verbindbar sind. Weiterhin besteht die Möglichkeit, dass die Montageplatte 22 an der Bodenplatte 2 oder an der Deckplatte 3 des Gehäuses 1 gegenüber der Ausgangsposition um 180° gedreht befestigbar ist, so dass allein mit einem einzigen Metallgehäuse über die verschieden gestalteten Montageplatten 22 bzw. 23 eine große Anzahl von Variationsmöglichkeiten gegeben sind.

Weiterhin besteht die Möglichkeit, dass das Metallgehäuse 1 im Fließpressverfahren hergestellt werden kann, so dass es möglich ist, Gehäuse in unterschiedlicher Länge ohne Mehrkosten zu fertigen. Allein durch Vorsehen eines nicht näher dargestellten Anschlages beim Ablängen können damit die verschiedensten Gehäusetypen hergestellt werden. Hierdurch ist es möglich, den Funktionsumfang zu erweitern und auch andere elektronische Baugruppen im Bedarfsfall in das Gehäuse 1 einzubringen.

Vorteilhafterweise wird damit durch die Erfindung nur noch ein Gehäusetyp benötigt, so dass sich eine Verringerung der Kosten der Lagerhaltung ergeben. Durch das Fließpressverfahren und durch die unterschiedlichsten Anbringungsmöglichkeiten der Montageplatten 22 und 23 wird hierdurch eine erhebliche Reduzierung der Kosten für ein Metallgehäuse erzielt.

Insgesamt ergibt sich damit ein einfach aufgebautes Metallgehäuse, insbesondere für ein Airbag-Steuergerät, welches bei erheblicher Reduzierung der Lagerhaltung für die verschiedensten Einbaumöglichkeiten unterschiedlicher Fahrzeugtypen verwendbar ist.

## Patentansprüche

1. Gehäuse (1), insbesondere für ein Airbag-Steuergerät, mit Boden- und Deckplatte (2, 3), mit einer Rückwand (4) und mit zwei Seitenwänden (5, 6), mit Aufnahmeelementen im Inneren des Gehäuses (1) für mindestens eine gedruckte Leiterplatte (10) und mit einem an der Vorderseite des Gehäuses angeordneten Anschlusselement (20) für mindestens ein Verbindungselement
**dadurch gekennzeichnet,**
**dass** das Gehäuse (1) ein Metallgehäuse ist und dass die Boden- und/oder die Deckplatte (2, 3) mit einer an einem Träger befestigbaren Montageplatte (22, 23) verbunden ist bzw. sind.

2. Gehäuse nach Anspruch 1, **dadurch gekennzeichnet, dass** die Bodenund/oder die Deckplatte (2, 3) des einstückig ausgebildeten Gehäuses (1) mit Vorsprüngen (40) versehen sind, welche in Ausnehmungen (45) der Montageplatte (22, 23) einlagerbar und verpressbar sind.

3. Gehäuse nach Anspruch 2, **dadurch gekennzeichnet, dass** die Vorsprünge (40) in mehreren parallelen Reihen (I, II, III, IV) verlaufen und aus auf der Boden- und/oder der Deckplatte (2, 3) angeformten Rippen und/oder Zeilen herausgearbeitet sind.

4. Gehäuse nach einem oder mehreren der vorhergehenden Ansprüche, **dadurch gekennzeichnet, dass** die Montageplatten (22, 23) die Bodenund/oder Deckplatte (2, 3) zumindest teilweise überragen und Befestigungsbereiche (50.1; 50.2; 51) aufweisen.

5. Gehäuse nach Anspruch 4, **dadurch gekennzeichnet, dass** die Befestigungsbereiche (50.1; 50.2; 51) mit mindestens einer durchgehenden Öffnung (55) versehen sind.

6. Gehäuse nach Anspruch 4 oder 5, **dadurch gekennzeichnet, dass** die eine mit drei Befestigungsbereichen (50.1, 50. 2, 51) versehene Montageplatte (22) entweder an der Bodenplatte (2) oder an der Deckplatte (3) des Gehäuses (1) befestigbar ist.

7. Gehäuse nach Anspruch 6, **dadurch gekennzeichnet, dass** die Montageplatte (22) an der Bodenplatte (2) oder an der Deckplatte (3) des Gehäuses (1) gegenüber der Ausgangsposition um 180° gedreht befestigbar ist.

8. Gehäuse nach einem oder mehreren der vorhergehenden Ansprüche 5 bis 7, **dadurch gekennzeichnet, dass** die Befestigungsbereiche (50.1, 50.2, 51) als Flansche oder als Teil einer Randleiste (28) ausgebildet sind.

9. Gehäuse nach einem oder mehreren der vorhergehenden Ansprüche, **dadurch gekennzeichnet, dass** die Seitenwände (5, 6) des einstückig ausgebildeten Gehäuses (1) und die Rückwand (4) mit Führungselementen (8, 8'; 18) für die Leiterplatte (10) versehen sind.

10. Gehäuse nach Anspruch 9, **dadurch gekennzeichnet, dass** die Führungselemente (8, 8') der Seitenwände (5, 6) als Nuten und die der Rückwand (4) als elektrisch leitende Kontakte (18) ausgebildet sind.

11. Gehäuse nach Anspruch 10, **dadurch gekennzeichnet, dass** die Kontakte (18) einen gabelförmigen Bereich (48) zum Beaufschlagen und Lagern der Leiterplatte (10) und einen mit der Rückwand (4) verbindbaren Bereich (49) aufweisen, welcher mit mindestens einer Öffnung (52) zum Einlagern und Verprägen mit mindestens einem Vorsprung (53) der Rückwand (4) versehen ist.

12. Gehäuse nach einem oder mehreren der vorhergehenden Ansprüche, **dadurch gekennzeichnet, dass** das Anschlusselement (20) über mindestens eine Rastverbindung (15) mit der Vorderseite des Gehäuses (1) verbindbar ist.

13. Gehäuse nach Anspruch 12, **dadurch gekennzeichnet, dass** im Bereich der Vorderseite des Gehäuses (1) Rastnasen (16) vorgesehen sind, welche in Rastausnehmungen (17) des aus Kunststoff bestehenden Anschlusselements (20) einklippbar sind.

14. Gehäuse nach einem oder mehreren der vorhergehenden Ansprüche, **dadurch gekennzeichnet, dass** zwischen dem Anschlusselement (20) und der Vorderseite des Gehäuses (1) eine umlaufende Kunststoffdichtung (25) vorgesehen ist.

15. Gehäuse nach einem oder mehreren der vorhergehenden Ansprüche, **dadurch gekennzeichnet, dass** das Gehäuse (1) im Fließpressverfahren herstellbar ist.

## Claims

1. Housing (1), in particular for an airbag control unit, having a base plate (2) and cover plate (3), having a rear wall (4) and having two side walls (5, 6), having accommodating elements in the interior of the housing (1) for at least one printed circuit board (10), and having an attachment element (20) which is arranged on the front side of the housing and is intended for at least one connecting element, **characterized in that** the housing (1) is a metal housing, and **in that** the base plate (2) and/or cover plate (3) is/are connected to a mounting plate (22, 23) which can be fastened on a carrier.

2. Housing according to Claim 1, **characterized in that** the base plate (2) and/or the cover plate (3) of the housing (1), which is formed in one piece, is/are provided with protrusions (40) which can be positioned in recesses (45) of the mounting plate (22, 23) and subjected to a pressing operation.

3. Housing according to Claim 2, **characterized in that** the protrusions (40) run in a number of parallel rows (I, II, III, IV) and are made from ribs and/or strips integrally formed on the base plate (2) and/or the cover plate (3).

4. Housing according to one or more of the preceding claims, **characterized in that** the mounting plates (22, 23) at least partially project beyond the base plate (2) and/or cover plate (3) and have fastening regions (50.1; 50.2; 51).

5. Housing according to Claim 4, **characterized in that** the fastening regions (50.1; 50.2; 51) are provided with at least one through-opening (55).

6. Housing according to Claim 4 or 5, **characterized in that** the one mounting plate (22) provided with three fastening regions (50.1, 50.2, 51) can be fastened either on the base plate (2) or on the cover plate (3) of the housing (1).

7. Housing according to Claim 6, **characterized in that** the mounting plate (22) can be fastened on the base plate (2) or on the cover plate (3) of the housing (1) in a state in which it is rotated through 180° in relation to the starting position.

8. Housing according to one or more of the preceding Claims 5 to 7, **characterized in that** the fastening regions (50.1, 50.2, 51) are designed as flanges or as part of a border strip (28).

9. Housing according to one or more of the preceding claims, **characterized in that** the side walls (5, 6) of the single-piece housing (1) and the rear wall (4) are provided with guide elements (8, 8'; 18) for the printed circuit board (10).

10. Housing according to Claim 9, **characterized in that** the guide elements (8, 8') of the side walls (5, 6) are designed as grooves and those of the rear wall (4) are designed as electrically conductive contacts (18).

11. Housing according to Claim 10, **characterized in that** the contacts (18) have a fork-like region (48), for acting on and bearing the printed circuit board (10), and a region (49), which can be connected to the rear wall (4) and is provided with at least one opening (52) in which at least one protrusion (53) of the rear wall (4) can be positioned and stamped.

12. Housing according to one or more of the preceding claims, **characterized in that** the attachment element (20) can be connected to the front side of the housing (1) via at least one latching connection (15).

13. Housing according to Claim 12, **characterized in that** provided in the region of the front side of the housing (1) are latching noses (16) which can be clipped into latching recesses (17) of the attachment element (20), which consists of plastic.

14. Housing according to one or more of the preceding claims, **characterized in that** an encircling plastic seal (25) is provided between the attachment element (20) and the front side of the housing (1).

15. Housing according to one or more of the preceding claims, **characterized in that** the housing (1) can be produced by extrusion.

## Revendications

1. Boîtier (1), en particulier pour un appareil de commande d'airbag, comportant une plaque de fond et une plaque de couverture (2, 3), une paroi arrière (4) et deux parois latérales (5, 6), des éléments de réception dans l'intérieur du boîtier (12) pour au moins une carte à circuits imprimés (10) et comportant un élément de raccordement (20) agencé sur le côté avant du boîtier pour au moins un élément de liaison,
**caractérisé en ce que**
le boîtier (1) est un boîtier métallique et **en ce que** la plaque de fond et/ou la plaque de couverture (2, 3) est/sont reliée(s) à une plaque de montage (22, 23) susceptible d'être fixée sur un support.

2. Boîtier selon la revendication 1, **caractérisé en ce que** la plaque de fond et/ou la plaque de couverture (2, 3) du boîtier (1) réalisé d'un seul tenant sont pourvues de saillies (40) qui sont susceptibles d'être montées et engagées à la presse dans des évidements (45) de la plaque de montage (22, 23).

3. Boîtier selon la revendication 2, **caractérisé en ce que** les saillies (40) s'étendent dans plusieurs rangées parallèles (I, II, III, IV) et sont usinées à partir de nervures et/ou de lignes conformées sur la plaque de fond et/ou sur la plaque de couverture (2, 3).

4. Boîtier selon l'une ou plusieurs des revendications précédentes, **caractérisé en ce que** les plaques de montage (22, 23) dépassent au moins partiellement au-delà de la plaque de fond et/ou de la plaque de couverture (2, 3) et présentent des zones de fixation (50.1 ; 50.2 ; 51).

5. Boîtier selon la revendication 4, **caractérisé en ce que** les zones de fixations (50.1 ; 50.2 ; 51) sont pourvues d'au moins une ouverture traversante (55).

6. Boîtier selon l'une ou l'autre des revendications 4 et 5, **caractérisé en ce que** l'une des plaques de montage (22) pourvue de trois zones de fixation (50.1, 50.2, 51) est susceptible d'être fixée soit sur la plaque de fond (2) soit sur la plaque de couverture (3) du boîtier (1).

7. Boîtier selon la revendication 6, **caractérisé en ce que** la plaque de montage (22) est susceptible d'être fixée sur la plaque de fond (2) ou sur la plaque de couverture (3) du boîtier (1) de façon tournée de 180° par rapport à la position initiale.

8. Boîtier selon l'une ou plusieurs des revendications 5 à 7, **caractérisé en ce que** les zones de fixation (50.1, 50.2, 51) sont réalisées sous forme de brides ou de partie d'une baguette de bordure (28).

9. Boîtier selon l'une ou plusieurs des revendications précédentes, **caractérisé en ce que** les parois latérales (5, 6) du boîtier (1) réalisé d'un seul tenant et la paroi arrière (4) sont pourvues d'éléments de guidage (8, 8' ; 18) pour la carte à circuits imprimés (10).

10. Boîtier selon la revendication 9, **caractérisé en ce que** les éléments de guidage (8, 8') des parois latérales (5, 6) sont réalisés sous forme de gorges et ceux de la paroi arrière (4) sont réalisés sous forme de contacts (18) conducteurs de l'électricité.

11. Boîtier selon la revendication 10, **caractérisé en ce que** les contacts (18) présentent une zone (48) en forme de fourche pour solliciter et monter la carte à circuits imprimés (10) et une zone (49) susceptible d'être reliée à la paroi arrière (4), zone qui est pourvue d'au moins une ouverture (52) pour le montage et l'engagement à la presse d'au moins une saillie (53) de la paroi arrière (4).

12. Boîtier selon l'une ou plusieurs des revendications précédentes, **caractérisé en ce que** l'élément de raccordement (20) est susceptible d'être relié au côté avant du boîtier (1) via au moins une liaison à enclenchement (15).

13. Boîtier selon la revendication 12, **caractérisé en ce que** des becs d'enclenchement (16) sont prévus dans la zone du côté avant du boîtier (1), qui sont susceptibles d'être encliquetés dans des évidements d'enclenchement (17) de l'élément de raccordement (20) constitué en matière plastique.

14. Boîtier selon l'une ou plusieurs des revendications précédentes, **caractérisé en ce qu'**il est prévu un joint périphérique (25) en matière plastique entre l'élément de raccordement (20) et le côté avant du boîtier (1).

15. Boîtier selon l'une ou plusieurs des revendications précédentes, **caractérisé en ce que** le boîtier (1) est susceptible d'être réalisé par un procédé de formage par fluage.
